# EUROPEAN PATENT APPLICATION

(11) **EP 2 610 917 A2**
(43) Date of publication of application: **03.07.2013**
(21) Application number: 12169408.7
(22) Date of filing: 24.05.2012
(51) Int. Cl.: H01L 31/0224, H01L 31/068

(54) **Solar cell having buried electrode**

(30) Priority: 28.12.2011 TW 100149233
(71) Applicant: AU Optronics Corporation, Hsin-Chu (TW)
(72) Inventor: Lai, Liang-Hsing, Hsin-Chu (TW); Hu, Yen-Cheng, Hsin-Chu (TW); Chen, Jen-Chieh, Hsin-Chu (TW); Wu, Zhen-Cheng, Hsin-Chu (TW)
(74) Representative: Lang, Christian

(57) **Abstract**

Disclosed herein is a solar cell (100), which includes a first electrode (110), a buried electrode (120), a photoelectric conversion layer (130) and a second electrode (140). The buried electrode (120) is disposed on the first electrode (110). The photoelectric conversion layer (130) is disposed over the first electrode and the buried electrode. The buried electrode is embedded in the photoelectric conversion layer. The second electrode (140) is arranged in a way such that the photoelectric conversion layer (130) is positioned between the first electrode (110) and the second electrode (140).

## Description

### RELATED APPLICATIONS

This application claims priority to Taiwan Application Serial Number 100149233, filed December 28, 2011, which is herein incorporated by reference.

### BACKGROUND

### Technical Field

The present invention relates to a solar cell. More particularly, the present invention relates to a solar cell having a buried electrode.

### Description of Related Art

Solar energy has gained much research attention for being a seemingly inexhaustible energy source. Solar cells are devices developed for such purpose by converting solar energy directly into electrical energy. Currently, solar cells are often made of single crystalline silicon and poly crystalline silicon, and such devices account for more than 90% of the solar cell market. Solar cells provide many advantages, but are not widely in use today because of their low photoelectric conversion efficiencies. In view of the above, researchers are devoted to increase the photoelectric conversion efficiencies of solar cells.

### SUMMARY

According to one aspect of the present disclosure, there is provided a solar cell with an improved efficiency of photoelectric conversion. The solar cell includes a first electrode, at least one buried electrode, a photoelectric conversion layer and a second electrode. The buried electrode is disposed on the first electrode. The photoelectric conversion layer is disposed over the first electrode and the buried electrode. The buried electrode is embedded in the photoelectric conversion layer. The second electrode is arranged in a way such that the photoelectric conversion layer is positioned between the first electrode and the second electrode.

According to one embodiment of the present disclosure, the second electrode has an area less than an area of the first electrode, and the buried electrode is not overlapped with the second electrode.

According to one embodiment of the present disclosure, the photoelectric conversion layer includes an emitter layer and a semiconductor layer. The emitter layer is disposed on the first electrode. The semiconductor layer is disposed on the emitter layer, in which a PN junction is formed between the emitter layer and the semiconductor layer.

According to one embodiment of the present disclosure, the semiconductor layer is an n-type silicon layer.

According to one embodiment of the present disclosure, the emitter layer includes a heavily doped portion that surrounds the buried electrode.

According to one embodiment of the present disclosure, the photoelectric conversion layer further comprises a surface-electric-field layer positioned on the semiconductor layer, and the surface-electric-field is in contact with the second electrode.

According to one embodiment of the present disclosure, the emitter layer is a p-type silicon layer.

According to one embodiment of the present disclosure, the second electrode is not in contact with the buried electrode.

According to one embodiment of the present disclosure, the solar cell further includes a light-trapping layer positioned on the photoelectric conversion layer, and the light-trapping layer has a rough surface.

According to one embodiment of the present disclosure, the buried electrode has a thickness of about 30 µ m to about 130 µm.

According to one embodiment of the present disclosure, the buried electrode has a width of about 5 µm to about 30 µm.

It is to be understood that both the foregoing general description and the following detailed description are by examples, and are intended to provide further explanation of the invention as claimed.

### BRIEF DESCRIPTION OF THE DRAWINGS

The invention can be more fully understood by reading the following detailed description of the embodiments, with reference made to the accompanying drawings as follows:

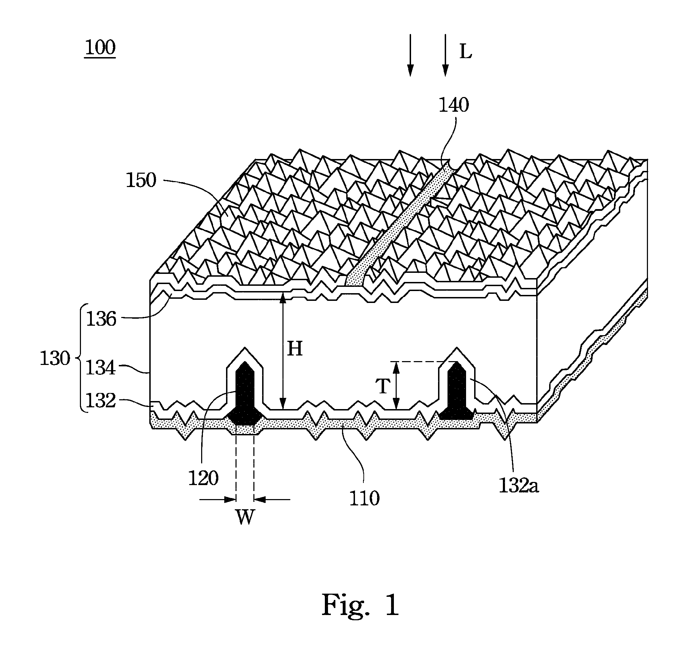

Fig. 1 is a perspective view schematically illustrating a solar cell according to one embodiment of the present disclosure.

### DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawings.

Fig. 1 is a perspective view schematically illustrating a solar cell 100 according to one embodiment of the present disclosure. The solar cell 100 includes a first electrode 110, at least one buried electrode 120, a photoelectric conversion layer 130 and a second electrode 140. An incident light L is transmitted to the photoelectric conversion layer 130 from the side of the second electrode 140, and the incident light is converted into electricity by the photoelectric conversion layer 130.

The first electrode 110 and the second electrode 140 are respectively disposed at opposite sides of the photoelectric conversion layer 130. The first and the second electrodes 110, 140 are operable to transmit the electricity generated by the solar cell 100 to an external loading device (not shown). The first electrode 110 is disposed on the side opposite to the light-receiving surface of the solar cell 100. In one embodiment, the first electrode 110 is blanket formed, and is located under the photoelectric conversion layer 130. The first electrode 110 may include metallic material such as aluminum, silver, copper or nickel. Various different types of physical vapor deposition processes may be employed to form the first electrode 110.

The second electrode 140 is disposed on the side of the incident light L, as depicted in Fig. 1. The second electrode 140 may be made of either a transparent conductive material or an opaque conductive material. When the second electrode 140 is made from an opaque conductive material, the second electrode 140 may be a patterned electrode according to one embodiment of the present disclosure. In particular, the second electrode 140 may have a stripe-shaped pattern or other patterns in a top view. In one example, the area of the second electrode 140 is less than the area of the first electrode 110 in a top view. The incident light L may reach the photoelectric conversion layer 130 through regions that are not covered by the second electrode 140. The second electrode 140 may be made of a material with high conductivity such as silver or copper. Alternatively, when the second electrode 140 is made of a transparent conductive material, the second electrode 140 may be a blanket layer without a specific pattern disposed on the photoelectric conversion layer 130. In this embodiment, the second electrode 140 may be made of a conductive oxide such as indium tin oxide, zinc oxide, tin oxide or zinc magnesium oxide.

The buried electrode 120 is disposed on the first electrode 110, and is configured to collect current carriers (i.e., electrons or electron holes) generated in the photoelectric conversion layer 130. The buried electrode 120 is made of a metallic material with high conductivity, and is electrically connected to the first electrode 110. The buried electrode 120 extends into the photoelectric conversion layer 130, and is embedded in the photoelectric conversion layer 130 to provide a short traveling path for the current carriers. When the current carriers are produced in the photoelectric conversion layer 130, the carriers travel to the buried electrode 120 instead of traveling to the first electrode 110, so that the traveling distances of the carriers may be reduced. As a result, the possibility of electron-hole recombination may be reduced. Accordingly, the photoelectric conversion efficiency of the solar cell 100 may be enhanced. In one embodiment, the buried electrode 120 is physically connected to the first electrode 110, and the thickness T of the buried electrode 120 is about 20% to 80% of the thickness H of the photoelectric conversion layer 130, preferably about 40% to about 70%. When the thickness T of the buried electrode 120 is too small, the function of the buried electrode 120 is undesirably limited. On the other hand, when the thickness of the buried electrode 120 is too thick, it would undesirably affect the surface structure of the light-receiving surface. Accordingly, according to one embodiment of the present disclosure, the thickness T of the buried electrode 120 is about 20% to about 80% of the thickness H of the photoelectric conversion layer 130. The buried electrode 120 is not in contact with the second electrode 140. The buried electrode 120 may be configured as a circular cylinder, a hexagonal cylinder or a cone in shape, for example. The thickness of the buried electrode 120 may be about 30 µ m to about 130 µ m, specifically about 50 µ m about 100 µ m. The width W of the buried electrode 120 may be, for example, about 5 µ m to about 30 µ m, specifically about 10 µ m to about 20 µ m.

In one embodiment, the buried electrode 120 is not overlapped with the second electrode 140 in a top view. Specifically, the second electrode 140 is configured as a patterned electrode, and the second electrode 140 is not overlapped with the buried electrode 120 when being viewed in a direction orthogonal to the photoelectric conversion layer 130. That is, the buried electrode 120 is not located at a position right beneath the second electrode 140. In the case where the second electrode 140 is an opaque patterned electrode, the second electrode 140 shelters a portion of the incident light L, so that the portion of the photoelectric conversion layer 130 right under the second electrode 140 receives little light and generates few current carriers. When the buried electrode 120 is positioned right below the second electrode 140, the effect of collecting current carriers by the buried electrode 120 is limited due to only few current carriers being produced in this region. Therefore, according to one embodiment of the present disclosure, the buried electrode 120 is preferably disposed at a position that is out of the region direct under the second electrode 140.

At least one feature of the buried electrode 120 relies on that the buried electrode 120 is positioned on the side opposite to the light-receiving surface of the solar cell 100, so that the buried electrode 120 does not shelter the incident light L. Accordingly, the number and the density of the buried electrode 120 may be increased, and also the disposition of the buried electrodes 120 may be configured and designed in a free manner.

The photoelectric conversion layer 130 is positioned between the first electrode 110 and the second electrode 140, and the photoelectric conversion layer 130 is disposed over the first electrode 110 and the buried electrode 120. The current carriers generated in the photoelectric conversion layer 130 may be transmitted to the first electrode 110 through the buried electrode 120 since the buried electrode 120 provides a short traveling path for the carriers, and thus reducing the possibility of electron-hole recombination. Therefore, the solar cell 100 has a high short-circuit current, and thus the photoelectric conversion efficiency is increased.

In one embodiment, the photoelectric conversion layer 130 includes an emitter layer 132, a semiconductor layer 134 and a surface-electric-field layer 136, as depicted in Fig. 1.

The semiconductor layer 134 is disposed on the emitter layer 132. The semiconductor layer 134 forms a PN junction with the emitter layer 132 at the interface there between. For instance, the semiconductor layer 134 may be a semiconductor layer such as an n-type silicon layer, and the emitter layer 132 may be a semiconductor layer such as a p-type silicon layer. Therefore, a PN junction is formed at the interface between the emitter layer 132 and the semiconductor layer 134. The thickness of the emitter layer 132 may be about 2-20 µ m, specifically about 5-15 µ m. In the example where the semiconductor layer 134 is a n-type silicon layer and the emitter layer 132 is a p-type silicon layer, the doping concentration of the n-type silicon layer is about 7 × 10¹⁴(1/cm³), and the doping concentration of the p-type silicon layer is about 2 × 10¹⁸(1/cm³)_{.}

The emitter layer 132 is disposed over the first electrode 110 and the buried electrode 120. The emitter layer 132 is conformally formed along surfaces of the first electrode 110 and the buried electrode 120. In this way, the area of the formed PN junction may be increased, and thus the photoelectric conversion efficiency of the photoelectric conversion layer 130 may be increased. In one example, the emitter layer 132 may include a heavily doped portion 132a that surrounds the buried electrode 120. The heavily doped portion 132a is configured to reduce the interface resistance between the buried electrode 120 and the semiconductor layer 134.

The surface-electric-field layer 136 is disposed on the semiconductor layer 134, and is in contact with the second electrode 140. In one example, the material of the surface-electric-field layer 136 is identical to that of the semiconductor layer 134, but the doping concentration of the surface-electric-field layer 136 is greater than that of the semiconductor layer 134. For instance, the surface-electric-field layer 136 may be an n-type silicon layer with a doping concentration of about 5 × 10¹⁹(1/cm³). The surface-electric-field layer 136 may be about 0.1 µ m to about 3 µ m in thickness. The surface-electric-field layer136 is configured to increase the build-in electric field in the photoelectric conversion layer 130.

In another embodiment, the solar cell 100 may further include a light-trapping layer 150 positioned on the side of the incident light L. The light-trapping layer 150 has a rough surface, and is disposed on the photoelectric conversion layer 130. When the incident light L is transmitted to the photoelectric conversion layer 130, the light-trapping layer 150 prevents the light from exiting the solar cell 100 through the reflection in the solar cell 100, and traps the incident light in the solar cell 100. Accordingly, the light transmitted into the photoelectric conversion layer 130 may be effectively absorbed by the photoelectric conversion layer 130, and thus increasing the photoelectric conversion efficiency. In this embodiment, it is important to dispose the buried electrode 120 on the first electrode 110 that is at the side opposite to the light-receiving surface of the solar cell. Since the buried electrode 120 is disposed on the first electrode, the buried electrode 120 would not unfavorably affect the rough surface of the light-trapping layer 150.

Table 1 shows photoelectric properties of a solar cell according to one embodiment of the present disclosure and a conventional solar cell without buried electrodes. The open-circuit voltage (Voc), short- circuit current density (Jsc), fill factor (F.F.) and photoelectric conversion efficiency (E) associated with the embodiment of the present disclosure are respectively 0.6331 V, 36.95 mA/cm², 79.12% and 18.51 %. In the conventional solar cell, the open-circuit voltage, short-circuit current density, fill factor and photoelectric conversion efficiency are respectively 0.6337 V, 36.62 mA/cm², 79.1% and 18.36%. The photoelectric conversion efficiency of the solar cell is increased due to the arrangement of the buried electrodes according to the embodiment of the present disclosure.

**Table 1**

| | Voc (V) | Jsc (mA/cm²) | F. F (%) | E (%) |
|---|---|---|---|---|
| With buried electrode | 0.6331 | 36.95 | 79.12 | 18.51 |
| Without buried electrode | 0.6337 | 36.62 | 79.10 | 18.36 |

According to another embodiment of the present disclosure, the solar cell 100 includes a first electrode 110, at least two buried electrodes 120, a photoelectric conversion layer 130 and a second electrode 140 having a stripe pattern, as depicted in Fig. 1. The two buried electrodes 120 are disposed on the first electrode, in which one of the buried electrodes is spaced apart from the other buried electrode. The photoelectric conversion layer 130 covers the first electrode 110 and the two buried electrodes 120. The two buried electrodes 120 are embedded in the photoelectric conversion layer 130. The second electrode 140 is disposed on the photoelectric conversion layer 130. The second electrode 140 is not in contact with the two buried electrodes 120. In one example, the second electrode 140 is located at a position between the two buried electrodes when being viewed in a direction orthogonal to the photoelectric conversion layer 130. In another example, a distance from one buried electrode 120 to the second electrode 140 is equal to a distance from another buried electrode 120 to the second electrode 140.

## Claims

1. A solar cell, comprising:
a first electrode;
at least one buried electrode disposed on the first electrode;
a photoelectric conversion layer positioned over the first electrode and the buried electrode, wherein the buried electrode is embedded in the photoelectric conversion layer; and
a second electrode arranged in a way such that the photoelectric conversion layer is positioned between the first electrode and the second electrode.

2. The solar cell according to claim 1, wherein the second electrode has an area less than an area of the first electrode, and the buried electrode is not overlapped with the second electrode in a direction orthogonal to the photoelectric conversion layer.

3. The solar cell according to claim 1, wherein the photoelectric conversion layer comprises:
an emitter layer disposed on the first electrode; and
a semiconductor layer disposed on the emitter layer, wherein a PN junction is formed between the emitter layer and the semiconductor layer.

4. The solar cell according to claim 3, wherein the semiconductor layer is an n-type silicon layer.

5. The solar cell according to claim 3, wherein the emitter layer comprises a heavily doped portion that surrounds the buried electrode.

6. The solar cell according to claim 3, wherein the photoelectric conversion layer further comprises a surface-electric-field layer positioned on the semiconductor layer, and the surface-electric-field is in contact with the second electrode.

7. The solar cell according to claim 3, wherein the emitter layer is a p-type silicon layer.

8. The solar cell according to claim 1, wherein the second electrode is not in contact with the buried electrode.

9. The solar cell according to claim 1, further comprising a light-trapping layer positioned on the photoelectric conversion layer, and the light-trapping layer has a rough surface.

10. The solar cell according to claim 1, wherein the buried electrode has a thickness of about 30 µ m to about 130 µ m.

11. The solar cell according to claim 1, wherein the buried electrode has a width of about 5 µ m to about 30 µ m.

12. The solar cell according to claim 1, wherein solar cell has a light-receiving surface, and the first electrode and the buried electrode are positioned on a side opposite to the light-receiving surface of the solar cell.

13. The solar cell according to claim 1, wherein the buried electrode has a thickness of about 40% to 70% of a thickness of the photoelectric conversion layer.

14. The solar cell according to claim 1, wherein the first electrode is a blanket layer formed under the photoelectric conversion layer.

15. The solar cell according to claim 1, wherein the solar cell has a light-receiving surface, and the second electrode is arranged on the side of the light-receiving surface.
